# EUROPEAN PATENT APPLICATION

(11) **EP 4 576 546 A1**
(43) Date of publication of application: **25.06.2025**
(21) Application number: 23891622.5
(22) Date of filing: 15.11.2023
(51) Int. Cl.: H02M 7/48, H02M 3/00, H05K 7/20

(54) **POWER SUPPLY MODULE**

(30) Priority: 16.11.2022 JP 2022183677; 16.11.2022 JP 2022183681
(71) Applicant: AISIN CORPORATION, Kariya-shi, Aichi 448-8650 (JP)
(72) Inventor: YAMASHITA, Mitsugi, Kariya-shi, Aichi 448-8650 (JP); MAEDA, Takuyo, Kariya-shi, Aichi 448-8650 (JP); KATSUDA, Takuya, Kariya-shi, Aichi 448-8650 (JP); KAMATA, Takahide, Kariya-shi, Aichi 448-8650 (JP); TAKAYAMA, Masaki, Kariya-shi, Aichi 448-8650 (JP); IIZUMI, Akihito, Kariya-shi, Aichi 448-8650 (JP)
(74) Representative: Kramer Barske Schmidtchen Patentanwälte PartG mbB
(86) International application number: PCT/JP2023/041119
(87) International publication number: WO 2024/106475

(57) **Abstract**

A power supply module (100) includes a drive board (20, 30) that drives an electronic circuit including a plurality of electronic components having different heights, a control board (40) that controls the drive board, and a housing (10) that houses the drive board and the control board, in which: an internal space (11) of the housing has a first region (11a) and a second region (11b) formed on both sides with respect to a virtual reference plane (50); and among the plurality of electronic components, the electronic components (22c) that are relatively tall are housed in a relatively tall region in the first region.

## Description

### TECHNICAL FIELD

The present disclosure relates to a power supply module.

### BACKGROUND ART

Conventionally, a power supply module on which circuits, such as an inverter and a converter, are mounted is known (see, e.g., Patent Literature 1). The power supply module converts the electric power supplied from, for example, a commercial power supply and charges a battery with the converted electric power, or converts the electric power supplied from a battery mounted on a vehicle such as an automobile and supplies the converted electric power to an electronic device such as a motor.

In addition, there is conventionally known a power supply module in which an electronic circuit, such as a converter circuit, and a control board that controls the electronic circuit are housed in an upper case and a lower case partitioned by a cooling partition wall (see, e.g., Patent Literature 2). This power supply module is miniaturized by housing the electronic circuit and the control board in the same case.

In the power supply module described in Patent Literature 1, the case is vertically partitioned, and the converter circuit is disposed in an upper space and the inverter circuit is disposed in a lower space. In addition, a cooling flow path through which cooling water flows is provided at a bottom portion of the lower space, and heat is transferred to the metal case to cool the converter circuit and the inverter circuit.

In the power supply module described in Patent Literature 2, an inlet and an outlet for cooling water are integrally formed on the side surface of the case main body, and in a state where the electronic circuit is housed in the upper case and the control board is housed in the lower case, an upper lid is fixed to the upper case and a lower lid is fixed to the lower case. In addition, a through hole is provided in the cooling partition wall, and a metal bus bar for electrically connecting a filter circuit and the electronic circuit provided below the through hole is drawn out of the through hole.

### CITATIONS LIST

### PATENT LITERATURE

Patent Literature 1: JP H11-121690 A
Patent Literature 2: WO 2015/133201 A

### SUMMARY OF INVENTION

### TECHNICAL PROBLEMS

Various electronic components having different heights, such as a switching element, a reactor, a capacitor, and a transformer, are used in a power supply module. Since the power supply module described in Patent Literature 1 secures a large upper space and a large lower space to dispose the converter circuit and the inverter circuit, there are restrictions on layout when the power supply module is mounted on a vehicle.

In addition, the converter circuit described in Patent Literature 2 is provided with a plurality of electronic components such as a capacitor, a reactor, a transformer, a high-voltage switching element, and a low-voltage switching element. However, the power supply module described in Patent Literature 1 does not disclose a specific configuration of the cooling partition wall that electrically connects these electronic components and the control board.

Therefore, a compact power supply module that can be mounted on a vehicle is desired. In addition, a power supply module that can achieve compactness and secure a conductive wire route crossing the cooling flow path is desired.

### SOLUTIONS TO PROBLEMS

A characteristic configuration of a power supply module according to the present disclosure includes: a drive board that drives an electronic circuit including a plurality of electronic components having different heights; a control board that controls the drive board; and a housing that houses the drive board and the control board, in which: an internal space of the housing has a first region and a second region formed on both sides with respect to a virtual reference plane;
and among the plurality of electronic components, the electronic components that are relatively tall are housed in a relatively tall region in the first region.

In the present configuration, a housing for housing the drive board and the control board is provided, and the internal space of the housing is divided into two regions with respect to the virtual reference plane. The electronic components that are tall are housed in the relatively tall region in the first region that is one of the two regions.

For example, a charger, such as an on-board charger mounted on a vehicle such as an electric car, includes tall electronic components, such as a reactor and a transformer, and hence when the electronic components are disposed in a tall region in the first region and the other low electronic components are disposed in the second region, the power supply module becomes compact. In addition, for example, the transformer that is relatively tall of the reactor and the transformer is disposed in the relatively tall region in the first region, so that space utilization efficiency can be enhanced.

As described above, a compact power supply module that can be mounted on a vehicle is obtained.

A characteristic configuration of a power supply module according to the present disclosure includes: a drive board that drives an electronic circuit including a plurality of electronic components; and a cooling plate through which a cooling fluid flows, in which any electronic component of the plurality of electronic components is disposed on an opposite side to the drive board with the cooling plate interposed therebetween, and a conductive wire that electrically connects the any electronic component and the drive board is fixed to a through hole formed in the cooling plate by a fixing means.

When any electronic component of the plurality of electronic components is disposed on the opposite side to the drive board with the cooling plate interposed therebetween as in the present configuration, space utilization efficiency can be enhanced and the compactness of the power supply module can be achieved.

In the present configuration, the conductive wire drawn out of the any electronic component disposed on the opposite side to the drive board with the cooling plate interposed therebetween is fixed to the through hole formed in the cooling plate by a fixing means. Therefore, it is not necessary to detour the conductive wire, and it becomes possible to route the conductive wire along the shortest route through the cooling flow path. In addition, since insulation is secured only by fixing to the through hole formed in the cooling plate by the fixing means, processing is easy.

As described above, a power supply module that can achieve compactness and secure a conductive wire route crossing the cooling flow path is obtained.

### BRIEF DESCRIPTION OF DRAWINGS

FIG. 1 is a circuit configuration diagram of a cooling system including a power supply module according to a first embodiment.
FIG. 2 is an exploded perspective view of the power supply module.
FIG. 3 is a longitudinal sectional view of the power supply module.
FIG. 4 is an enlarged view of a part B in FIG. 3.
FIG. 5 is a sectional view taken along line V-V in FIG. 2.
FIG. 6 is a partial longitudinal sectional view of a power supply module according to a second embodiment.
FIG. 7 is a partial longitudinal sectional view of a power supply module according to a third embodiment.
FIG. 8 is a partially enlarged plan view of the power supply module.
FIG. 9 is a sectional view taken along line IX-IX in FIG. 8.

### DESCRIPTION OF EMBODIMENTS

Hereinafter, embodiments of a power supply module according to the present disclosure will be described in detail with reference to the drawings. Note that the embodiments described below are examples for explaining the present disclosure, and the present disclosure is not limited only to these embodiments. Therefore, the present disclosure can be implemented in various forms without departing from the gist thereof.

### [Configuration of cooling circuit]

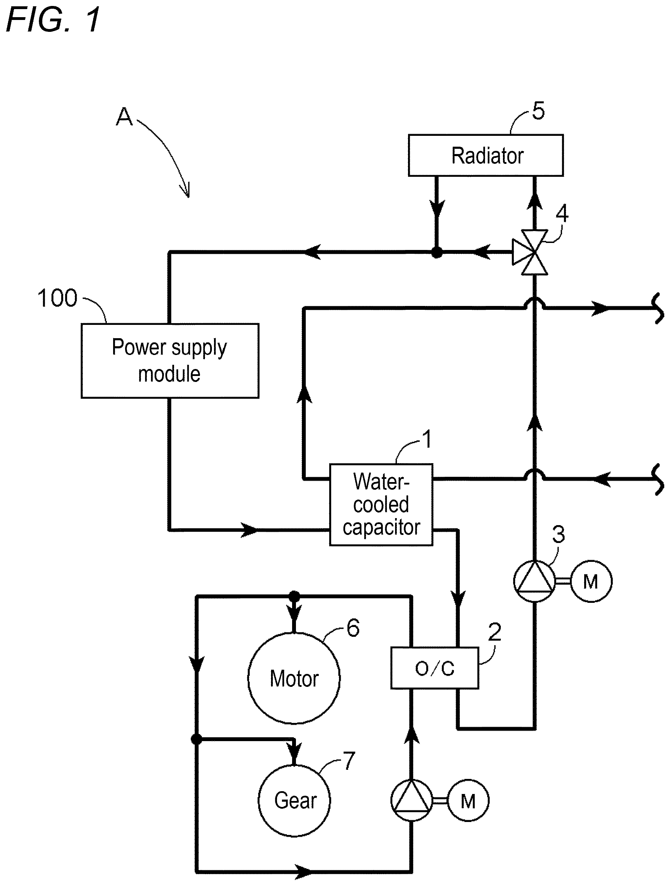

As illustrated in FIG. 1, a cooling circuit A including a power supply module 100 according to the present embodiment cools the power supply module 100 with a cooling fluid. The cooling fluid is cooling water such as a long life coolant (LLC), insulating oil such as paraffin-base oil, or a refrigerant such as hydrofluorocarbon (HFC) or hydrofluoroolefin (HFO). In the present embodiment, it is preferable to use cooling water, such as a long life coolant (LLC), or a liquid having high electrical insulation such as a fluorine-based inert liquid, and a cooling liquid composed of cooling water or insulating oil may be used. The cooling circuit A is mounted on a vehicle that charges a battery (not illustrated) with external electric power.

The cooling circuit A includes the power supply module 100, a water-cooled capacitor 1, an oil cooler 2, a water pump 3, a three-way valve 4, and a radiator 5. The cooling fluid heated by cooling the power supply module 100 flows out of the power supply module 100, exchanges heat with a refrigerant in the water-cooled capacitor 1 to be heated, and then exchanges heat with the lubricating oil in the oil cooler 2 to be further heated. Thereafter, the cooling fluid is pumped by the water pump 3, and is switched by the three-way valve 4 between a case where the cooling fluid is fed to the radiator 5 and a case where the cooling fluid is not fed to the radiator 5. When the cooling fluid is fed to the radiator 5, the cooling fluid is cooled in the radiator 5 and flows into the power supply module 100 again. When the cooling fluid is not fed to the radiator 5, the cooling fluid flows into the power supply module 100 again in a heated state without being cooled.

### [First embodiment]

### [Configuration of power supply module]

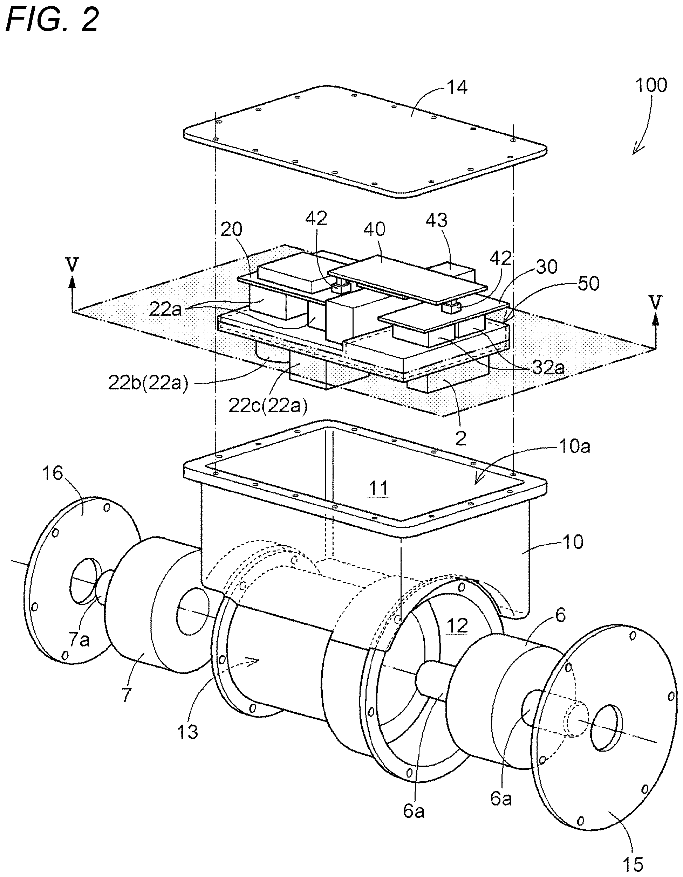

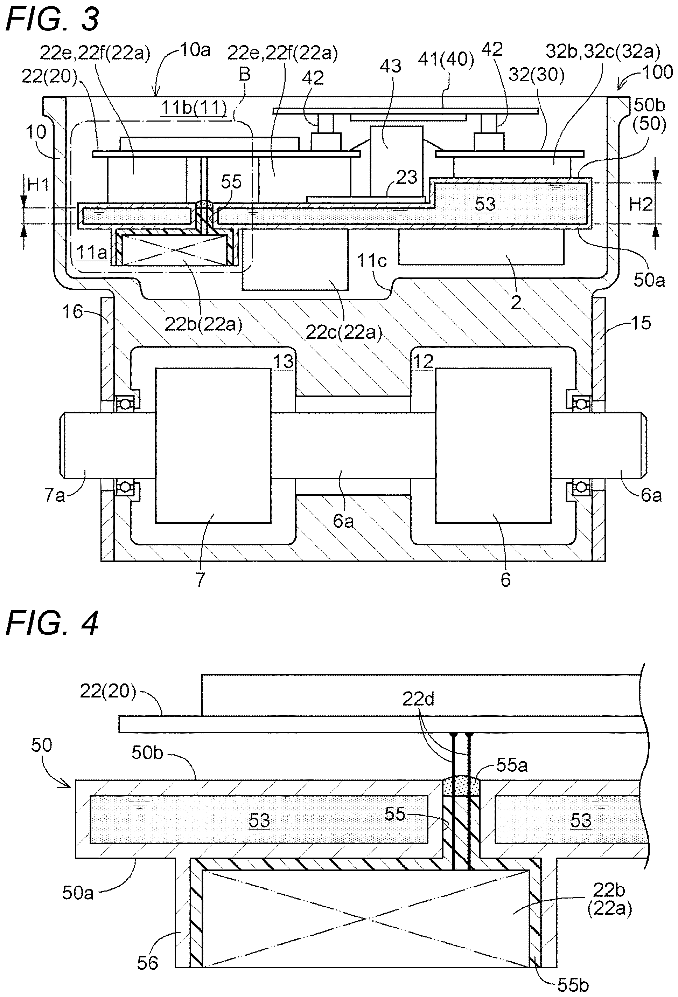

As illustrated in FIG. 2, the power supply module 100 according to the first embodiment is configured to house at least an on board charger (OBC) board 20 (an example of the drive board), a motor drive board 30 (an example of the drive board), and a control board 40 that controls the OBC board 20 and the motor drive board 30 in a housing 10. The power supply module 100 has a first space 11 (an example of the internal space). The OBC board 20, the motor drive board 30, and the control board 40 are separate boards, each of which is housed in the first space 11 in a mutually parallel orientation. FIG. 3 illustrates a section cut in a direction perpendicular to the plate surface of the OBC board 20 (motor drive board 30, control board 40). Hereinafter, the direction perpendicular to the plate surface of the OBC board 20 is referred to as a "vertical direction". In FIG. 3, a direction along the vertical direction in which the control board 40 is viewed from the OBC board 20 and the motor drive board 30 is referred to as an "upward direction", an "upper side", or the like, and a direction in which the OBC board 20 and the motor drive board 30 are viewed from the control board 40 is referred to as a "downward direction", a "lower side", or the like.

The housing 10 has a second space 12 and a third space 13 that are partitioned from the first space 11. The second space 12 and the third space 13 are positioned below the first space 11. A motor 6 driven by the motor drive board 30 is housed in the second space 12, and a gear mechanism 7 that decelerates and outputs the rotation of the motor 6 is housed in the third space 13. The housing 10 has an opening 10a on the upper side of the first space 11, and the OBC board 20, the motor drive board 30, the control board 40, and a cooling plate 50 are housed in the first space 11 from the opening 10a. The opening 10a is closed by a lid 14 (see FIG. 2), and the first space 11 becomes a closed space. The second space 12 houses the motor 6 from the side, and becomes a closed space by being closed by a motor cover 15 fastened with bolts (not illustrated). A motor shaft 6a extends from the motor 6 along the rotational axis on both sides, and the motor shaft 6a on one side passes through the motor cover 15 and is exposed outside the housing 10. The motor shaft 6a on the other side passes through to the third space 13. The third space 13 houses the gear mechanism 7 from the side, and becomes a closed space by being closed by a gear cover 16 fastened with bolts (not illustrated). The motor shaft 6a on the other side, extending from the second space 12, is connected to the gear mechanism 7, and the rotation of the motor 6 is input via the motor shaft 6a. The gear mechanism 7 decelerates the rotation of the motor 6 and outputs the decelerated rotation from a gear shaft 7a. The gear shaft 7a passes through the gear cover 16 and is exposed outside the housing 10. Hereinafter, the motor 6 and the gear mechanism 7 are also collectively referred to as a drive unit. In the present embodiment, the drive unit is housed in the housing 10 together with the power supply module 100 and integrated therewith, and is disposed in the motor room of an electric vehicle. The electric vehicle is a vehicle including a motor as a traveling drive source, and is, for example, a hybrid electric vehicle (HEV), a plug-in hybrid electric vehicle (PHEV), a battery electric vehicle (BEV), or a fuel cell electric vehicle (FCEV). Note that the power supply module 100 may be provided separately from the drive unit in the electric vehicle.

A power converter 22 (an example of the electronic circuit) is mounted on the OBC board 20. The power converter 22 includes at least an AC-DC converter that converts an alternating current input from the outside into a direct current, and a DC-DC converter that converts a direct current voltage into a direct current voltage suitable for charging a battery (not illustrated). Since the configurations of the AC-DC converter and the DC-DC converter are known, detailed description thereof will be omitted.

A power converter 32 (an example of the electronic circuit) is mounted on the motor drive board 30. The power converter 32 includes at least an inverter that controls a drive current for driving the motor 6. Since the configuration of the inverter is known, detailed description thereof will be omitted. In addition, a control circuit 41 that controls the power converter 22 and the power converter 32 is mounted on the control board 40.

The AC-DC converter and the DC-DC converter of the power converter 22 include a heat-generating component 22a (an example of the electronic component), and the inverter of the power converter 32 includes a heat-generating component 32a (an example of the electronic component). Examples of the heat-generating component 22a included in the power converter 22 include a reactor 22b (an example of the electronic component that is relatively low), a transformer 22c (an example of the electronic component that is relatively tall), a diode 22e (an example of the electronic component that is relatively low), and a switching element 22f (an example of the electronic component that is relatively low). Examples of the heat-generating component 32a included in the power converter 32 include a diode 32b (an example of the electronic component that is relatively low) and a switching element 32c (an example of the electronic component that is relatively low). These electronic components have different heights.

In the present embodiment, the OBC board 20 and the motor drive board 30 are positioned at the same height in the vertical direction. The control board 40 is disposed to overlap the OBC board 20 and the motor drive board 30 when viewed along the vertical direction (vertical view). A board-to-board connector 42 is used for the connection between the OBC board 20 and the control board 40 and the connection between the motor drive board 30 and the control board 40. Hereinafter, the board-to-board connector 42 is simply referred to as a connector 42. In the present embodiment, the OBC board 20 and the motor drive board 30 are positioned at the same height in the vertical direction, and hence the OBC board 20 and the control board 40, and the motor drive board 30 and the control board 40, can be connected by using two connectors 42 of one type. With such a configuration, the control board 40 can be easily assembled to the OBC board 20 and the motor drive board 30, and it is not necessary to use different types of connectors, so that assemblability is also excellent.

### [Cooling plate]

In the first space 11 of the housing 10, a cooling plate 50 (an example of the virtual reference plane) that cools the heat-generating component 22a of the power converter 22 and the heat-generating component 32a of the power converter 32 is housed. The cooling plate 50 is made of a metal having a high thermal conductivity such as aluminum, and is integrally formed by joining a lower plate 50a and an upper plate 50b, which have a plate shape, by a method such as welding. A space is formed in the cooling plate 50 (between the lower plate 50a and the upper plate 50b), and the cooling fluid flows through the space. The heat-generating component 22a is mounted on the lower surface of the OBC board 20, and the heat-generating component 32a is mounted on the lower surface of the motor drive board 30. Both the heat-generating component 22a and the heat-generating component 32a are disposed to be in contact with the cooling plate 50, and when heat is exchanged between the heat-generating components 22a and 32a and the cooling fluid, the temperatures of the heat-generating components 22a and 32a are lowered and the temperature of the cooling fluid is raised. Both the heat-generating component 22a and the heat-generating component 32a may be disposed to be fixed to the cooling plate 50.

As described above, the OBC board 20 and the motor drive board 30 are positioned at the same height in the vertical direction. In order to realize this, the power supply module 100 of the present embodiment includes a height adjustment mechanism. Specifically, a flow path height H1 in the vertical direction at an area facing the OBC board 20 (an area overlapping the OBC board 20 in the vertical view) is made different from a flow path height H2 in the vertical direction at an area facing the motor drive board 30 (an area overlapping the motor drive board 30 in the vertical view). In the present embodiment, the flow path height H2 is larger than the flow path height H1. That is, the height adjustment mechanism of the present embodiment varies the flow path heights H1 and H2 in the cooling plate 50 according to the facing boards.

In the present embodiment, in the lower plate 50a and the upper plate 50b constituting the cooling plate 50, the lower plate 50a has a flat plate shape, but the upper plate 50b has different heights at an area corresponding to the OBC board 20 and at an area corresponding to the motor drive board 30. Specifically, with respect to the lower plate 50a, the height at the area, corresponding to the motor drive board 30, of the upper plate 50b is larger than the height at the area corresponding to the OBC board 20. As described above, the heat-generating component 22a used in the power converter 22 of the OBC board 20 and the heat-generating component 32a used in the power converter 32 of the motor drive board 30 are both cooled by being brought into contact with the upper plate 50b of the cooling plate 50. That is, the heat-generating component 22a of the power converter 22 has a large mounting height, and the heat-generating component 32a of the power converter 32 of the motor drive board 30 has a small mounting height.

Therefore, in the upper plate 50b of the present embodiment, the height of the flow path height H2 is made larger than the flow path height H1 by an amount corresponding to the difference between the mounting height of the heat-generating component 22a and the mounting height of the heat-generating component 32a. This makes it possible to align the vertical heights of the OBC board 20 and the motor drive board 30 in a state where the heat-generating component 22a that is tall and the heat-generating component 32a that is low are both brought into contact with the upper plate 50b.

In general, the amount of the heat generated by the heat-generating component 32a of the power converter 32 of the motor drive board 30 is relatively larger than the amount of the heat generated by the heat-generating component 22a of the power converter 22 of the OBC board 20. Therefore, by making the flow path height H2, with which the heat-generating component 32a is in contact, larger than the flow path height H1 with which the heat-generating component 22a is in contact, the flow path cross-sectional area of the cooling fluid, at an area with which the heat-generating component 32a is in contact, can be made larger than the flow path cross-sectional area of the cooling fluid at an area with which the heat-generating component 22a is in contact. As a result, the heat-generating component 32a can be efficiently cooled.

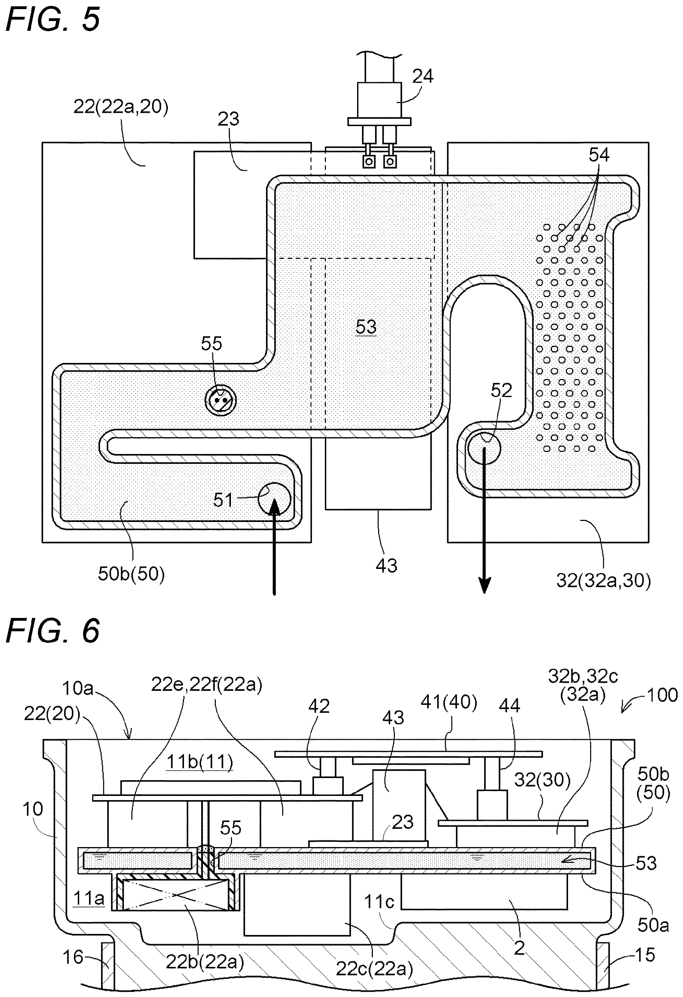

A flow path 53 of the cooling plate 50 is disposed as illustrated in FIG. 5 in the vertical view. In the present embodiment, when the cooling fluid flows in from an inlet 51 for the cooling fluid in the cooling plate 50, the cooling fluid first flows through an area corresponding to the heat-generating component 22a of the power converter 22 of the OBC board 20 on the upstream side, then flows through an area corresponding to the heat-generating component 32a of the power converter 32 of the motor drive board 30 on the downstream side, and flows out of an outlet 52. That is, the cooling fluid first cools the heat-generating component 22a having relatively low heat generation, and then cools the heat-generating component 32a having relatively high heat generation. If the flow path configuration is such that the cooling fluid first cools the heat-generating component 32a and then cools the heat-generating component 22a, the cooling fluid is sufficiently heated by the cooling of the heat-generating component 32a, and hence the heat-generating component 22a cannot be sufficiently cooled. However, by configuring the flow path 53 so as to cool the heat-generating component 22a and then cool the heat-generating component 32a, the cooling fluid can efficiently cool both the heat-generating components 22a and 32a.

A plurality of protrusions 54 are formed in the flow path 53 on the downstream side, facing the heat-generating component 32a, of the flow path 53. The protrusions 54 are formed on at least one of the upper plate 50b and the lower plate 50a so as to protrude from the outside toward the inside in a manner that obstructs the flow of the cooling fluid. The protrusions 54 have a spherical cap shape and are disposed in a staggered pattern in the flow direction of the cooling fluid. For example, when the protrusions 54 are disposed on the lower plate 50a, water on a side close to the lower plate 50a is lifted toward the upper plate 50b by the protrusions 54, creating a vortex. As a result, the cooling fluid on a side close to the upper plate 50b and the cooling fluid on the side close to the lower plate 50a are mixed, and the water temperature on the side close to the upper plate 50b can be lowered. Since the cooling fluid on the side close to the upper plate 50b with a lowered water temperature can absorb more heat, the temperature of the heat-generating component 32a can be further lowered.

As illustrated in FIGS. 3 and 5, a metal base board 23 is disposed on the upper plate 50b. A film capacitor 43 to be described later and a connection terminal 24 to which a direct-current voltage from a battery (not illustrated) is input are attached to the metal base board 23.

### [Film capacitor]

As described above, the OBC board 20 and the motor drive board 30 are separate boards. In the present embodiment, the film capacitor 43 (an example of the electronic component) is disposed between the OBC board 20 and the motor drive board 30, as illustrated in FIG. 2. The film capacitor 43 is used both for smoothing the inverter of the power converter 32 and for smoothing the secondary side of the DC-DC converter of the power converter 22. That is, the film capacitor 43 serves dual purposes for smoothing.

The film capacitor 43 has a height in the vertical direction from the vicinity of the upper plate 50b of the cooling plate 50 to the vicinity of the control board 40. That is, the vertical height of the film capacitor 43 is larger than the vertical height of the electronic component including the heat-generating component 22a mounted on the OBC board 20 and the vertical height of the electronic component including the heat-generating component 32a mounted on the motor drive board 30. Therefore, the periphery of the motor drive board 30 is surrounded by the control board 40, the film capacitor 43, and the wall surface of the housing 10, and is partitioned from the periphery of the OBC board 20. Therefore, the heat generated in the power converter 32 of the motor drive board 30 can be suppressed from being transmitted to the OBC board 20 side.

### [Disposing tall electronic components]

As illustrated in FIG. 3, the first space 11 is partitioned by the cooling plate 50, an example of the virtual reference plane, into a first region 11a positioned below the cooling plate 50 and a second region 11b positioned above the cooling plate 50. In the present embodiment, the volume of the first region 11a is smaller than the volume of the second region 11b. In the first space 11, a plurality of electronic components (including the heat-generating component 22a) constituting the power converter 22 and a plurality of electronic components (including the heat-generating component 32a) constituting the power converter 32 are disposed separately in the first region 11a and the second region 11b. The OBC board 20, the motor drive board 30, and the control board 40 are disposed in the second region 11b.

In the present embodiment, the reactor 22b and the transformer 22c of the power converter 22, and the oil cooler 2 are disposed in the first region 11a. In the second region 11b, the diodes 22e and 32b, the switching elements 22f and 32c, and the like of the power converter 22 and the power converter 32 are disposed. The reactor 22b, the transformer 22c, and the oil cooler 2 disposed in the first region 11a are in contact with the lower plate 50a of the cooling plate 50, and the diodes 22e and 32b and the switching elements 22f and 32c disposed in the second region 11b are in contact with the upper plate 50b. Among the electronic components, the electronic components that are relatively tall are housed and disposed in the first region 11a, and the electronic components that are relatively low are housed and disposed in the second region 11b.

The first region 11a is adjacent to the second space 12 where the motor 6 is disposed and the third space 13 where the gear mechanism 7 is disposed via the wall of the housing 10. That is, the first region 11a faces the motor 6 and the gear mechanism 7 via the wall of the housing 10. The first region 11a has a recess 11c recessed toward the third space 13 at an area facing the gear mechanism 7. As a result, the area of the first region 11a where the recess 11c is formed has a large height (depth) on the lower side (the side toward the gear mechanism 7) from the virtual reference plane (the lower plate 50a of the cooling plate 50).

Of the reactor 22b and the transformer 22c disposed in the first region 11a, the transformer 22c is relatively taller. Therefore, in the present embodiment, the reactor 22b is disposed at an area not facing the recess 11c, and the transformer 22c is disposed at an area facing the recess 11c, as illustrated in FIG. 3. The transformer 22c is disposed in such a manner that a part of it fits into the recess 11c. By disposing the reactor 22b and the transformer 22c in this manner, the recess 11c of the first region 11a can be effectively utilized, leading to the miniaturization of the power supply module 100.

### [Securing insulation by potting]

In the present embodiment, the reactor 22b and the transformer 22c are disposed in the first region 11a of the first space 11, the OBC board 20 is disposed in the second region 11b, and the first region 11a and the second region 11b are partitioned by the cooling plate 50. A pair of conductive wires 22d (an example of lead wires) positioned at both ends of the coil winding of the reactor 22b needs to be electrically connected to the OBC board 20. Therefore, in the present embodiment, a configuration will be described with reference to FIG. 4, in which a through hole 55 is formed in the cooling plate 50 and the conductive wire 22d of the reactor 22b is inserted through the through hole 55 to be electrically connected to the OBC board 20. Although not described in the present embodiment, the same configuration can be applied to the conductive wire of the coil winding of the transformer 22c and other electronic components disposed in the first region 11a.

First, a method for forming the through hole 55 will be described. The upper plate 50b and the lower plate 50a of the cooling plate 50 are joined to each other by forming a hole using friction stir welding from the upper plate 50b toward the lower plate 50a. That is, the through hole 55 is formed in the flow path 53, as illustrated in FIG. 4, but the periphery of the through hole 55 is surrounded by the joined upper plate 50b and lower plate 50a, and the cooling fluid flowing through the flow path 53 does not leak out of the through hole 55 to the through hole 55.

Next, the reactor 22b is disposed in a reactor housing portion 56 (an example of the concave portion) formed in the lower plate 50a, and the conductive wire 22d is inserted through the through hole 55. Accordingly, the conductive wire 22d is exposed to the second region 11b. The terminal of the conductive wire 22d is electrically connected to the OBC board 20.

Next, a sealant 55a is dropped onto the end on the second region 11b side of the through hole 55 to seal the end. Accordingly, the conductive wire 22d is fixed. Then, the reactor housing portion 56 is filled with a potting material 55b (an example of the fixing means) made of resin. The potting material 55b covers the entire circumference (entire side surface) and the bottom surface of the reactor 22b and also flows into the through hole 55. When the potting material 55b is cured, the insulation of the reactor 22b and the conductive wire 22d is secured by the potting material 55b injected between each of them and the cooling plate 50 (the lower plate 50a and the upper plate 50b).

As described above, with a simple configuration in which the through hole 55 is formed in the cooling plate 50 to insert the conductive wire 22d therethrough and the potting material 55b is injected, the insulation of each of the reactor 22b and the conductive wire 22d with respect to the cooling plate 50 can be secured, and the risk of the conductive wire 22d breaking can also be suppressed because the conductive wire 22d does not need to be routed over a long distance from the outside of the cooling plate 50.

### [Effects of first embodiment]

In the present embodiment, a power supply module 100, including an OBC board 20 and a motor drive board 30 that respectively drive power converters 22 and 32, such as converters and inverters, and a control board 40 that controls these boards, is obtained. That is, the control board 40, including the CPU and the like that operate the OBC board 20 and the motor drive board 30, is commonly used, and hence it is only necessary to connect the common control board 40 to the OBC board 20 and the motor drive board 30 using the respective connectors 42, leading to excellent assemblability.

In the cooling plate 50 of the present embodiment, a flow path 53, for allowing the cooling fluid to flow through from the heat-generating component 22a having relatively low heat generation toward the heat-generating component 32a having relatively high heat generation, is formed. Therefore, it is possible to prevent the other electronic components from being heated by the cooling fluid heated by the heat-generating component 32a having relatively high heat generation. In addition, the heat-generating component 22a having relatively low heat generation is first cooled, so that the heat-generating component 32a having relatively high heat generation can also be cooled by the cooling fluid.

In the present embodiment, included are a film capacitor 43 that partitions the OBC board 20 and the motor drive board 30, and the control board 40 that suppresses heat transfer from the motor drive board 30 to the OBC board 20 with the film capacitor 43 interposed therebetween. As a result, the power converter 22 controlled by the OBC board 20 and the power converter 32 controlled by the motor drive board 30 can be made independent cooling targets by the film capacitor 43 and the control board 40. Moreover, heat is shielded by the film capacitor 43, so that it is not necessary to separately provide a member for heat shielding, leading to the compactness of the power supply module 100.

In the present embodiment, a housing 10 that houses the OBC board 20, the motor drive board 30, and the control board 40 is included, which divides the first space 11 of the housing 10 into the first region 11a and the second region 11b with respect to the cooling plate 50. The reactor 22b and the transformer 22c, which are electronic components that are tall, are housed in a region having a relatively large volume in the first region 11a that is one of these two regions. When the reactor 22b and the transformer 22c are disposed in the first region 11a having a large volume of the first space 11, and the other electronic components that are low are disposed in the second region 11b, as described above, the power supply module 100 becomes compact. In addition, the transformer 22c that is relatively tall of the reactor 22b and the transformer 22c is disposed in the relatively tall region in the first region 11a, so that space utilization efficiency can be enhanced.

In the present embodiment, the conductive wire 22d, drawn out of the reactor 22b disposed on the opposite side to the OBC board 20 with the cooling plate 50 interposed therebetween, is fixed to the through hole 55 formed in the cooling plate 50 by the potting material 55b. Therefore, it is not necessary to detour the conductive wire 22d, and it becomes possible to route the conductive wire along the shortest route through the flow path 53. Moreover, since insulation is secured only by fixing to the through hole 55 formed in the cooling plate 50 by the potting material 55b, processing is easy.

### [Second Embodiment]

Next, a configuration of a power supply module 100 according to a second embodiment will be described with reference to FIG. 6. In the present embodiment, the flow path height of a cooling plate 50 is made constant, unlike the first embodiment. Therefore, an OBC board 20 and a motor drive board 30 are different in vertical position (vertical distance) when viewed from a control board 40. Specifically, the vertical distance between the control board 40 and the motor drive board 30 is larger than that in the first embodiment. Other configurations are similar to those of the first embodiment. Therefore, in the description of the present embodiment, parts having the same configurations as those of the first embodiment are denoted by the same reference signs, and detailed descriptions of the same configurations are omitted.

In the present embodiment, a height adjustment mechanism is provided in order to control a power converter 22 of the OBC board 20 and a power converter 32 of the motor drive board 30 by a control circuit 41 of the common control board 40. The height adjustment mechanism in the present embodiment is to make the height of a connector connecting the OBC board 20 and the control board 40 different from the height of a connector connecting the motor drive board 30 and the control board 40. Specifically, the motor drive board 30 and the control board 40 are connected by using a high-profile board-to-board connector 44 that is taller than the connector 42 (hereinafter, it is also simply referred to as a high-profile connector 44). As a result, even when the vertical positions of the OBC board 20 and the motor drive board 30, when viewed from the control board 40, are different, the power converter 22 of the OBC board 20 and the power converter 32 of the motor drive board 30 can be controlled using the common control board 40.

When the high-profile connector 44, having a different height from that of the connector 42, is used as in the present embodiment, and when the OBC board 20 and the motor drive board 30 are assembled to the common control board 40, one of the OBC board 20 and the motor drive board 30 is connected to the control board 40 and then the other board is connected to the control board 40, whereby a tolerance can be absorbed by the connector 42 and the high-profile connector 44.

### [Third embodiment]

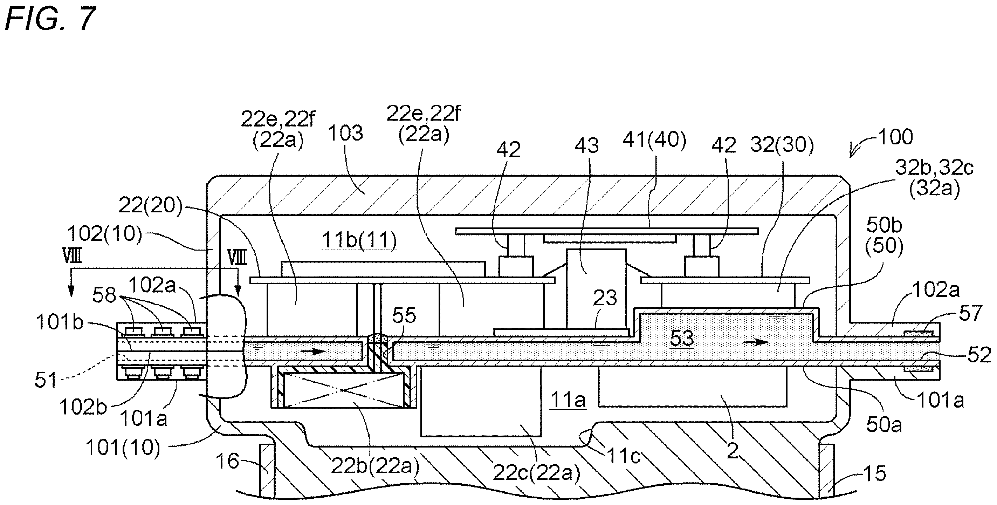

Next, a configuration of a power supply module 100 according to a third embodiment will be described with reference to FIGS. 7 to 9. The present embodiment is different from the first and second embodiments in the configuration of a cooling plate 50. Other configurations are similar to those of the first and second embodiments. Therefore, in the description of the present embodiment, parts having the same configurations as those of the first and second embodiments are denoted by the same reference signs, and detailed descriptions of the same configurations are omitted.

In the present embodiment, a housing 10 is configured by joining a first housing 101 and a second housing 102. The cooling plate 50 is disposed at the boundary between the first housing 101 and the second housing 102. Therefore, a first region 11a of a first space 11 is formed by the first housing 101 and the cooling plate 50, and a second region 11b of the first space 11 is formed by the second housing 102 and the cooling plate 50. Therefore, a reactor 22b and a transformer 22c are housed in the first housing 101.

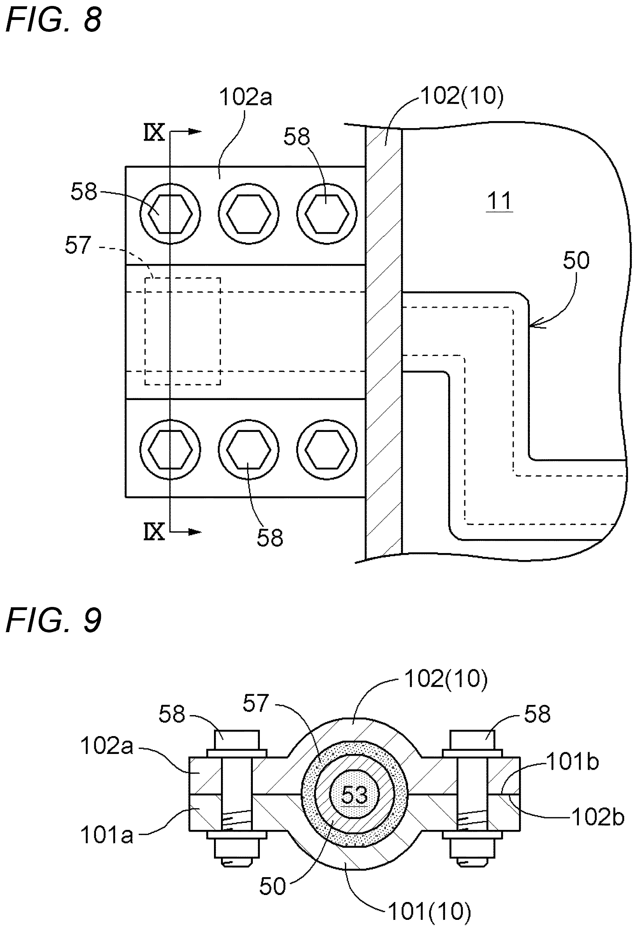

An inlet 51 and an outlet 52 of the cooling plate 50 are formed in a cylindrical shape as illustrated in FIG. 9. The inlet 51 and the outlet 52 are formed at both ends in the horizontal direction (direction parallel to the plate surface of the OBC board 20) of the cooling plate 50, as illustrated in FIG. 7. The inlet 51 and the outlet 52 are sandwiched between a first contact surface 101b of a first projection 101a of the first housing 101 and a second contact surface 102b of a second projection 102a of the second housing 102. The end of the inlet 51 and the end of the outlet 52 are exposed and visible from the outside of the housing 10. The inlet 51 and the outlet 52 are connected to the cooling plate 50 by screw connection.

The first projection 101a of the first housing 101 and the second projection 102a of the second housing 102 are fastened by a bolt 58 in a state where the first contact surface 101b and the second contact surface 102b are in contact with each other to sandwich the inlet 51 and the outlet 52 of the cooling plate 50, as illustrated in FIGS. 8 and 9. An annular gasket 57 is disposed between the inlet 51 and the first and second projections 101a and 102a, and between the outlet 52 and the first and second projections 101a and 102a, respectively. Furthermore, the second housing 102 becomes a cooling manifold 103 in which a flow path (not illustrated) constituting a part of a flow path 53 of the cooling plate 50 is formed inside, as illustrated in FIG. 7.

In the cooling plate 50 of the present embodiment, the inlet 51 and the outlet 52 for the cooling fluid are sandwiched between the first contact surface 101b of the first projection 101a of the first housing 101 and the second contact surface 102b of the second projection 102a of the second housing 102, respectively. Therefore, the flow path 53 to be formed inside the cooling plate 50 can be designed by the cooling plate 50 alone, resulting in high flexibility in designing a flow path shape. In addition, both ends of the cooling plate 50 in which the inlet 51 and the outlet 52 for the cooling fluid are formed are sandwiched by the first contact surface 101b of the first housing 101 and the second contact surface 102b of the second housing 102, so that the first housing 101, the cooling plate 50, and the second housing 102 may be assembled in this order, thereby ensuring assemblability.

### [Other embodiments]

(1) In the first embodiment, the recess 11c is provided in an area facing the gear mechanism 7, but may be provided in an area facing the motor 6.
(2) In the first embodiment, the reactor 22b is an electronic component that is relatively low and the transformer 22c is an electronic component that is relatively tall, but the present invention is not limited thereto. Even an electronic component other than the reactor 22b or the transformer 22c, which is relatively taller than other electronic components, may be disposed in the recess 11c.
(3) In the above embodiments, a configuration has been described as an example, in which the OBC board 20 and the motor drive board 30 are controlled by the common control board 40. However, a board to be housed in the housing 10 may be only one of the OBC board 20 and the motor drive board 30, or the OBC board 20 and the motor drive board 30 may be controlled by different control boards 40, respectively.
(4) In the first embodiment, the conductive wire 22d is inserted through the through hole 55, but a terminal of any electronic component, not limited to the conductive wire 22d, may be inserted through the through hole 55.
(5) In the first embodiment, the reactor 22b and the conductive wire 22d are fixed by the potting material 55b, but they may be fixed by a material other than the potting material 55b as long as the material is an insulating one.
(6) In the first embodiment, the reactor 22b is housed in the reactor housing portion 56 and the entire circumference of the reactor 22b is covered with the potting material 55b, but the present invention is not limited thereto. It may be configured such that only the conductive wire 22d is fixed by the potting material 55b and the reactor 22b is not covered with the potting material 55b. In this case, it is not necessary to provide the reactor housing portion 56.

In the above embodiments, the following configurations are envisioned.

<1> A characteristic configuration of a power supply module (100) according to the present disclosure includes: drive boards (20, 30) that drive electronic circuits (22, 32) including a plurality of electronic components (22b, 22c, 22e, 22f, 32b, 32c) having different heights; a control board (40) that controls the drive boards (20, 30); and a housing (10) that houses the drive boards (20, 30) and the control board (40), in which: in an internal space (11) of the housing (10), a first region (11a) and a second region (11b) are formed on both sides with respect to a virtual reference plane (50); and among the plurality of electronic components (22b, 22c, 22e, 22f, 32b, 32c), the electronic components (22b, 22c) that are relatively tall are housed in a relatively tall region in the first region (11a).

In the present configuration, the housing (10) that houses the drive boards (20, 30) and the control board (40) is provided, and the internal space (11) of the housing (10) is divided into two regions with respect to the virtual reference plane (50). In the first region (11a) that is one of the two regions, the electronic components (22b, 22c) that are tall are housed in a relatively tall region.

For example, a charger, such as an on-board charger mounted on a vehicle such as an electric car, includes tall electronic components, such as the reactor (22b) or the transformer (22c), and hence when the electronic components are disposed in a tall region in the first region (11a) and the other low electronic components (22e, 22f, 32b, 32c) are disposed in the second region (11b), the power supply module (100) becomes compact. In addition, for example, the transformer (22c) that is relatively tall of the reactor (22b) and the transformer (22c) is disposed in a relatively tall region in the first region (11a), so that space utilization efficiency can be enhanced.

As described above, a compact power supply module (100) that can be mounted on a vehicle is obtained.

<2> In the power supply module (100) of the above <1>, it is preferable that: a member forming the virtual reference plane (50) be a cooling plate (50) through which a cooling fluid flows; among the plurality of electronic components (22b, 22c, 22e, 22f, 32b, 32c), the electronic components (22e, 22f, 32b, 32c) that are relatively low be housed and disposed in the second region (11b); and the electronic components (22b, 22c) that are relatively tall be housed and disposed in the first region (11a).

When the electronic components (22e, 22f, 32b, 32c) that are low and the electronic components (22b, 22c) that are tall are disposed with the cooling plate (50) interposed therebetween as in the present configuration, the electronic components (22e, 22f, 32b, 32c) that are low can be concentrated in the second region (11b), and the electronic components (22b, 22c) that are tall can be concentrated in the first region (11a). For example, when electronic components that are low, such as switching elements (22e, 22f, 32b, 32c), are disposed in the second region (11b), not only the electronic components (22e, 22f, 32b, 32c) that are low but also the drive boards (20, 30) and the control board (40) can be disposed in the second region (11b), and space utilization efficiency is improved. In addition, the first region (11a) and the second region (11b) are formed by the cooling plate (50) and the housing (10), so that the cooling efficiency of electronic components can be enhanced.

<3> In the power supply module (100) of the above <2>, it is preferable that: the electronic component that is relatively tall be a transformer (22c); and the electronic components that are relatively low be diodes (22e, 32b) or switching elements (22f, 32c).

When the diodes (22e, 32b) or the switching elements (22f, 32c) are disposed as in the present configuration, not only the electronic components (22e, 22f, 32b, 32c) that are low but also the drive boards (20, 30) and the control board (40) can be disposed in the second region (11b), so that space utilization efficiency is improved.

<4> In the power supply module (100) of the above <3>, the housing (10) is characterized in that: the first region (11a) faces a gear mechanism (7); the first region (11a) has a recess (11c) recessed toward the gear mechanism (7); and at least a part of the transformer (22c) is disposed in the recess (11c).

When the recess (11c) recessed toward the gear mechanism (7) is provided in the first region (11a) of the housing (10) and at least a part of the transformer (22c) is disposed in the recess (11c) as in the present configuration, the power supply module (100) can be made compact.

<5> In the power supply module (100) of any one of the above <1> to <4>, the drive boards (20, 30) and the control board (40) are characterized by being housed in a second space (12) having an opening (10a) that can be closed by a lid (14).

When the drive boards (20, 30) and the control board (40) are disposed in the second region (11b) where the electronic components that are low, such as the switching elements (22e, 22f, 32b, 32c), are disposed as in the present configuration, space utilization efficiency is improved. In addition, the second region (11b) has the opening (10a) that can be closed by the lid (14), and hence the opening can be closed by the lid (14) after the control board (40) is assembled to the drive boards (20, 30), thereby improving assemblability.

<6> In the power supply module (100) of the above <1>, the drive boards (20, 30) are characterized by including a plurality of boards that respectively drive the plurality of electronic circuits (22, 32).

When the plurality of drive boards (20, 30) controlled by the control board (40) are provided as in the present configuration, the control board (40) configured by a CPU or the like that operates the plurality of drive boards (20, 30) is commonly used. Therefore, it is only necessary to connect the common control board (40) to the plurality of drive boards (20, 30) by connectors (42,44), leading to excellent assemblability.

<7> A characteristic configuration of a power supply module (100) according to the present disclosure includes: drive boards (20, 30) that drive electronic circuits (22, 32) including a plurality of electronic components (22b, 22c, 22e, 22f, 32b, 32c); and a cooling plate (50) through which a cooling fluid flows, in which any electric component (22b) of the plurality of electronic components is disposed on an opposite side to the drive boards (20, 30) with the cooling plate (50) interposed therebetween, and a conductive wire (22d) that electrically connects the any electronic component (22b) and the drive boards (20, 30) is fixed to a through hole (55) formed in the cooling plate (50) by a fixing means (55b).

When any electronic component (22b) of the plurality of electronic components is disposed on the opposite side to the drive boards (20, 30) with the cooling plate (50) interposed therebetween as in the present configuration, space utilization efficiency can be enhanced and the compactness of the power supply module (100) can be achieved.

In this configuration, the conductive wire (22d), drawn out of the any electronic component (22b) disposed on the opposite side to the drive boards (20, 30) with the cooling plate (50) interposed therebetween, is fixed to the through hole (55) formed in the cooling plate (50) by the fixing means (55b). Therefore, it is not necessary to detour the conductive wire (22d), and it becomes possible to route the conductive wire along the shortest route through the cooling flow path.

As described above, the power supply module (100) that can achieve compactness and secure a conductive wire route crossing the cooling flow path is obtained.

<8> In the power supply module (100) of the above <7>, it is preferable that the fixing means be a potting material (55b) injected into the through hole (55).

When the fixing means is the potting material (55b) injected into the through hole (55) as in the present configuration, insulation is secured only by fixing to the through hole (55) formed in the cooling plate (50) by the potting material (55b), so that processing is easy.

<9> In the power supply module (100) of the above <7> or <8>, it is preferable that: the cooling plate (50) include a lower plate (50a) and an upper plate (50b); the cooling fluid flow between the lower plate (50a) and the upper plate (50b); heat-generating components (22a, 32a) be in contact with a surface, on an opposite side to a side where the cooling fluid flows, of the upper plate (50b); and the heat-generating components (22a, 32a) be provided on surfaces, on a side facing the upper plate (50b), of the drive boards (20, 30).

When the heat-generating components (22a, 32a) are disposed in the drive boards (20, 30) as in the present configuration, the heat-generating components (22a, 32a) can be efficiently cooled by the cooling fluid in the cooling plate (50).

<10> In the power supply module (100) of any one of the above <7> to <9>, it is preferable that the through hole (55) be disposed in a flow path (53) for the cooling fluid in a state of being sealed with a sealant (55a).

When the through hole (55) is sealed with the sealant (55a) as in the present configuration, it is possible to have the conductive wire (22d) cross the cooling flow path only by injecting a fixing means, such as a potting material (55b), into the through hole (55), so that processing is easy.

<11> In the power supply module (100) of any one of the above <7> to <9>, it is preferable that: the any electronic component (22b) include a coil; and the conductive wire (22d) be a pair of lead wires positioned at both ends of winding of the coil.

When the coil used in the reactor (22b) or the transformer (22c) that is tall is disposed on the opposite side to the drive boards (20, 30) with the cooling plate (50) interposed therebetween as in the present configuration, space utilization efficiency can be enhanced. In addition, it is possible to firmly fix the lead wire (22d), which is likely to be displaced, by a fixing means such as the potting material (55b).

<12> In the power supply module (100) of the above <8>, it is preferable that the potting material (55b) surround the entire circumference of the coil.

When the potting material (55b) is provided on the entire circumference of the coil as in the present configuration, the coil can be stably fixed to the cooling plate (50).

<13> In the power supply module (100) of any one of the above <7> to <9>, it is preferable that the any electronic component (22b) be housed in a concave portion (56) integrally formed with the cooling plate (50).

When the electronic component (22b) is housed in the concave portion (56) integrally formed with the cooling plate (50) as in the present configuration, the fixing means, such as the potting material (55b), is guided to the concave portion (56), and the coil can be stably fixed to the cooling plate (50).

### [Industrial applicability]

The present disclosure can be applied to a power supply module.

### REFERENCE SIGNS LIST

7: Gear mechanism, 10: Housing, 10a: Opening, 11: First space (internal space), 11a: First region, 11b: Second region, 11c: Recess, 12: Second space, 14: Lid, 20: OBC board (drive board), 22: Power converter (electronic circuit), 22a: Heat-generating component (electronic component), 22b: Reactor (electronic component that is relatively low), 22c: Transformer (electronic component that is relatively tall), 22d: Conductive wire (lead wire), 22e: Diode (electronic component that is relatively low), 22f: Switching element (electronic component that is relatively low), 30: Motor drive board (drive board), 32: Power converter (electronic circuit), 32a: Heat-generating component (electronic component), 32b: Diode (electronic component that is relatively low), 32c: Switching element (electronic component that is relatively low), 40: Control board, 50: Cooling plate (virtual reference plane), 50a: Lower plate, 50b: Upper plate, 53: Flow path, 55: Through hole, 55a: Sealant, 55b: Fixing means (potting material), 56: Reactor housing portion (concave portion), and 100: Power supply module

## Claims

1. A power supply module comprising:
a drive board that drives an electronic circuit including a plurality of electronic components having different heights;
a control board that controls the drive board; and
a housing that houses the drive board and the control board, wherein
an internal space of the housing has a first region and a second region formed on both sides with respect to a virtual reference plane, and
among the plurality of electronic components, the electronic components that are relatively tall are housed in a relatively tall region in the first region.

2. The power supply module according to claim 1, wherein
a member forming the virtual reference plane is a cooling plate through which a cooling fluid flows, and
among the plurality of electronic components, the electronic components that are relatively low are housed and disposed in the second region, and the electronic components that are relatively tall are housed and disposed in the first region.

3. The power supply module according to claim 2, wherein
the electronic component that is relatively tall is a transformer, and
the electronic components that are relatively low are diodes or switching elements.

4. The power supply module according to claim 3, wherein
the first region of the housing faces a gear mechanism,
the first region has a recess recessed toward the gear mechanism, and
at least a part of the transformer is disposed in the recess.

5. The power supply module according to any one of claims 1 to 4, wherein the drive board and the control board are housed in the second region having an opening that can be closed by a lid.

6. The power supply module according to claim 1, wherein the drive board includes a plurality of boards that respectively drive the plurality of the electronic circuits.

7. A power supply module comprising:
a drive board that drives an electronic circuit including a plurality of electronic components; and
a cooling plate through which a cooling fluid flows, wherein
any electronic component of the plurality of electronic components is disposed on an opposite side to the drive board with the cooling plate interposed therebetween, and
a conductive wire that electrically connects the any electronic component and the drive board is fixed to a through hole formed in the cooling plate by a fixing means.

8. The power supply module according to claim 7, wherein the fixing means is a potting material injected into the through hole.

9. The power supply module according to claim 7 or 8, wherein
the cooling plate include a lower plate and an upper plate,
the cooling fluid flow between the lower plate and the upper plate,
a heat-generating component is in contact with a surface, on an opposite side to a side where the cooling fluid flows, of the upper plate, and
the heat-generating component is provided on a surface, on a side facing the upper plate, of the drive board.

10. The power supply module according to claim 7 or 8, wherein the through hole is disposed in a flow path for the cooling fluid in a state of being sealed with a sealant.

11. The power supply module according to claim 8, wherein
the any electronic component includes a coil, and
the conductive wire is a pair of lead wires positioned at both ends of winding of the coil.

12. The power supply module according to claim 11, wherein the potting material surrounds an entire circumference of the coil.

13. The power supply module according to claim 7 or 8, wherein the any electronic component is housed in a concave portion integrally formed with the cooling plate.
